# EUROPEAN PATENT SPECIFICATION

(11) **EP 4 528 696 B1**
(45) Date of publication and mention of the grant of the patent: **19.08.2026**
(21) Application number: 23839777.2
(22) Date of filing: 16.05.2023
(51) Int. Cl.: G09F 9/30, H04M 1/02, G06F 1/16

(54) **FOLDABLE ELECTRONIC DEVICE COMPRISING COVER WINDOW**
FALTBARE ELEKTRONISCHE VORRICHTUNG MIT ABDECKFENSTER
DISPOSITIF ÉLECTRONIQUE PLIABLE COMPRENANT UNE FENÊTRE DE COUVERTURE

(30) Priority: 13.07.2022 KR 20220086058; 17.08.2022 KR 20220102481
(43) Date of publication of application: 26.03.2025
(73) Proprietor: Samsung Electronics Co., Ltd., Suwon-si, Gyeonggi-do 16677 (KR)
(72) Inventor: MOON, Youngmin, Suwon-si, Gyeonggi-do 16677 (KR); BAE, Jaehyun, Suwon-si, Gyeonggi-do 16677 (KR); LEE, Changsu, Suwon-si, Gyeonggi-do 16677 (KR); KANG, Dongkyeong, Suwon-si, Gyeonggi-do 16677 (KR); SHIN, Chulsoo, Suwon-si, Gyeonggi-do 16677 (KR)
(74) Representative: Gulde & Partner
(86) International application number: PCT/KR2023/006629
(87) International publication number: WO 2024/014683

(56) References cited:
- KR-A- 20210 056 102
- KR-A- 20210 056 103
- KR-A- 20210 144 974
- KR-A- 20220 039 004
- KR-A- 20220 079 401

## Description

### [Technical Field]

The disclosure relates to a foldable electronic device including a cover window.

### [Background Art]

Owing to the development of information and communication technology and semiconductor technology, various functions are integrated in a single portable electronic device. For example, an electronic device may implement not only a communication function but also an entertainment function such as games, a multimedia function such as music/video playback, a communication and security function such as mobile banking, schedule management, and an electronic wallet function. Such electronic devices are miniaturized so that users may conveniently carry them.

As mobile communication services are extended to the multimedia service area, there is a need to increase the size of a display in an electronic device so that a user may sufficiently use multimedia services as well as voice calls or short messages. However, the size of the display of the electronic device and miniaturization of the electronic device are in a trade-off relationship.

KR 2021 0144974 A discloses an example of a flexible glass cover window for foldable display devices, comprising a thin upper glass plate, two spaced thicker lower glass plates, and an adhesive layer extending between and bonding these plates to improve flexibility, strength and durability at the folding region.

### [Detailed Description of the Invention]

### [Technical Solution]

According to an embodiment of the disclosure, an electronic device includes a housing including a first housing and a second housing rotatably connected to the first housing, a foldable display connected to the first housing and the second housing, and a cover window protecting the foldable display, and including a first flat area connected to the first housing, a second flat area connected to the second housing, and a bending area located between the first flat area and the second flat area. The cover window includes a protective layer forming at least a portion of an outer surface of the cover window, a glass including a first glass at least partially located in the first flat area and a second glass spaced apart from the first glass and at least partially located in the second flat area, a first adhesive layer at least partially located between the protective layer and the glass and having a first hardness, a second adhesive layer at least partially located between the glass and the display and having a second hardness, and a third adhesive layer surrounded by the glass, the first adhesive layer, and the second adhesive layer and having a third hardness greater than the first hardness and less than the second hardness.

According to an embodiment of the disclosure, a cover window includes a protective layer, a glass including a first glass and a second glass, a first adhesive layer at least partially located between the protective layer and the glass and at least partially having a first hardness, a second adhesive layer at least partially located under the glass and having a second hardness, and a third adhesive layer surrounded by the glass, the first adhesive layer, and the second adhesive layer and having a third hardness greater than the first hardness and less than the second hardness.

### [Brief Description of Drawings]

FIG. 1 is a block diagram illustrating an electronic device in a network environment according to an embodiment of the disclosure.
FIG. 2 is a diagram illustrating an electronic device in an unfolded state according to an embodiment of the disclosure.
FIG. 3 is a diagram illustrating an electronic device in a folded state according to an embodiment of the disclosure.
FIG. 4 is an exploded perspective view illustrating an electronic device according to an embodiment of the disclosure.
FIG. 5 is a cross-sectional view illustrating a folded cover window according to an embodiment of the disclosure.
FIGS. 6A, 6B and 6C are diagrams referred to for describing a process of manufacturing a cover window according to an embodiment of the disclosure. FIGS. 6D and 6E are diagrams illustrating the shape of a glass according to an embodiment of the disclosure.
FIG. 7 is a cross-sectional view illustrating a cover window according to an embodiment of the disclosure.
FIG. 8 is a cross-sectional view illustrating a cover window according to an embodiment of the disclosure.
FIG. 9 is a cross-sectional view illustrating a cover window according to an embodiment of the disclosure.
FIG. 10 is a cross-sectional view illustrating a folded cover window according to an embodiment of the disclosure.

### [Mode for Carrying out the Invention]

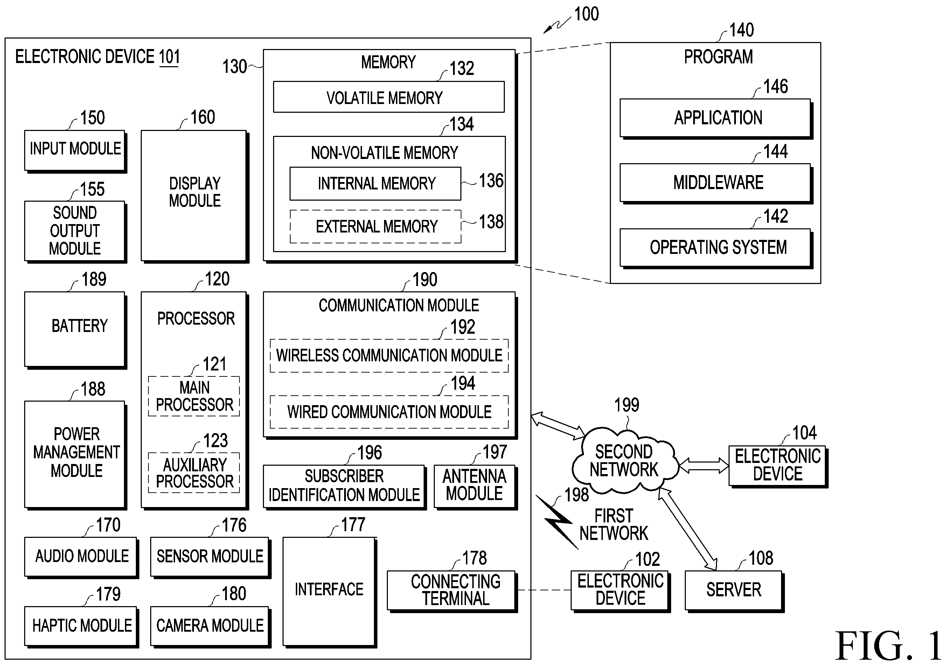

FIG. 1 is a block diagram illustrating an electronic device in a network environment according to an embodiment of the disclosure.

Referring to FIG. 1, an electronic device 101 in a network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) (e.g., a speaker or a headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

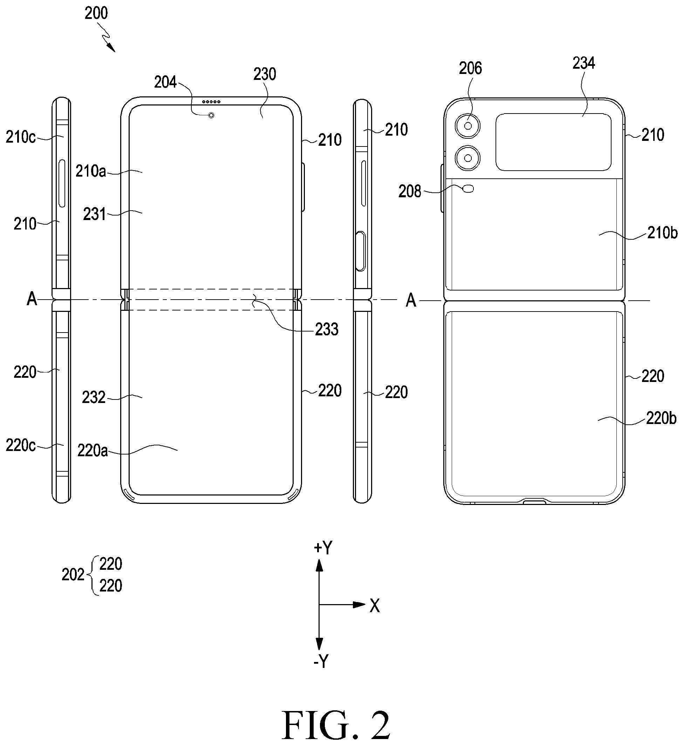

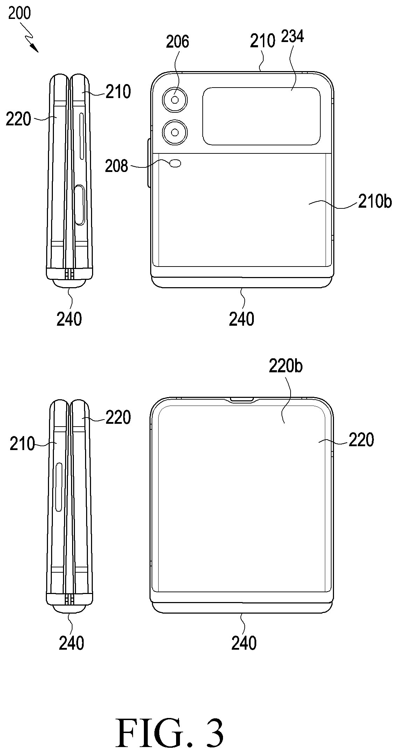

FIG. 2 is a diagram illustrating an electronic device in an unfolded state according to an embodiment of the disclosure. FIG. 3 is a diagram illustrating an electronic device in a folded state according to an embodiment of the disclosure. The configuration of an electronic device 200 in FIGS. 2 and 3 may be wholly or partially identical to that of the electronic device 101 in FIG. 1.

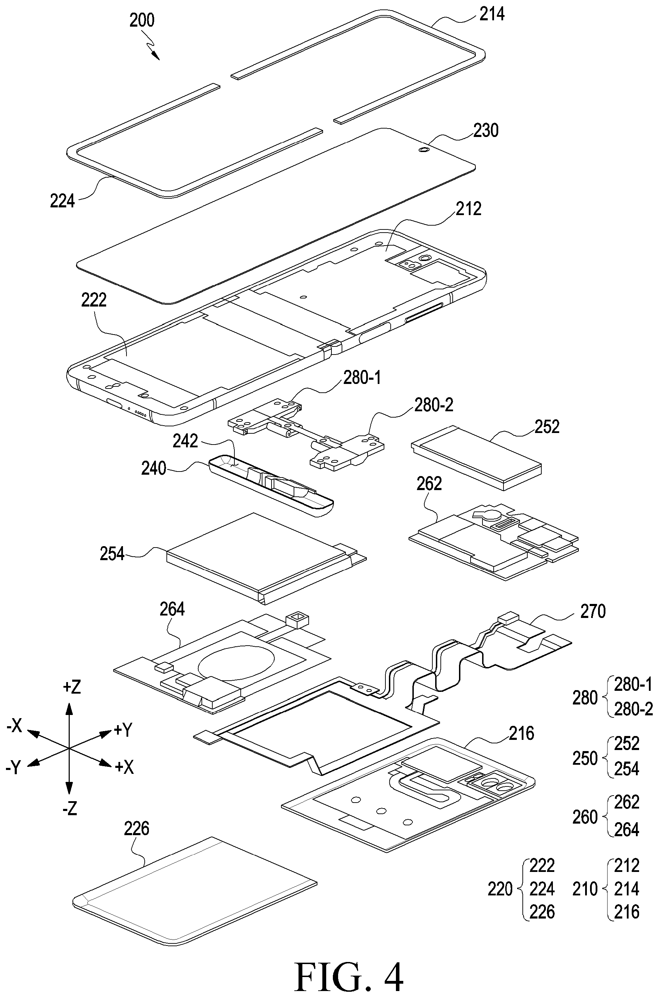

Referring to FIGS. 2 and 3, the electronic device 200 may include a housing 202 to accommodate components (e.g., a battery 250 and/or a circuit board 260 in FIG. 4) of the electronic device 200 therein, and a flexible display or foldable display 230 (hereinafter, referred to as a display 230) connected to the housing 202. According to an embodiment, the housing 202 may be referred to as a foldable housing.

According to an embodiment, the housing 202 may include a first housing 210 and a second housing 220 configured to rotate relative to the first housing 210.

According to an embodiment, the first housing 210 and/or the second housing 220 may form at least part of the exterior of the electronic device 200. According to an embodiment, a surface on which the display 230 is visually exposed is defined as a front surface (e.g., a first front surface 210a and a second front surface 220a) of the electronic device 200 and/or the housing 202. A surface opposite to the front surface is defined as a rear surface (e.g., a first rear surface 210b and a second rear surface 220b) of the electronic device 200. A surface surrounding at least part of a space between the front and rear surfaces is defined as a side surface (e.g., a first side surface 210c and a second side surface 220c) of the electronic device 200.

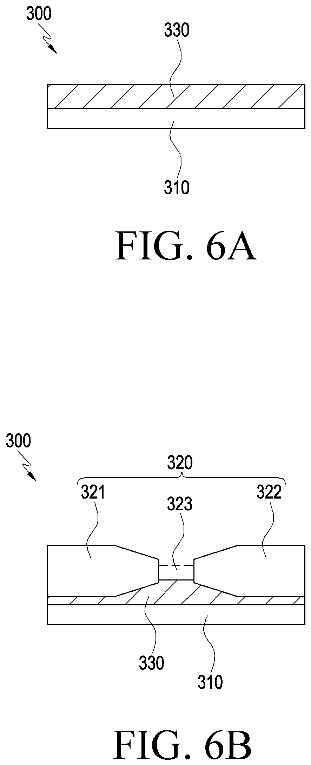

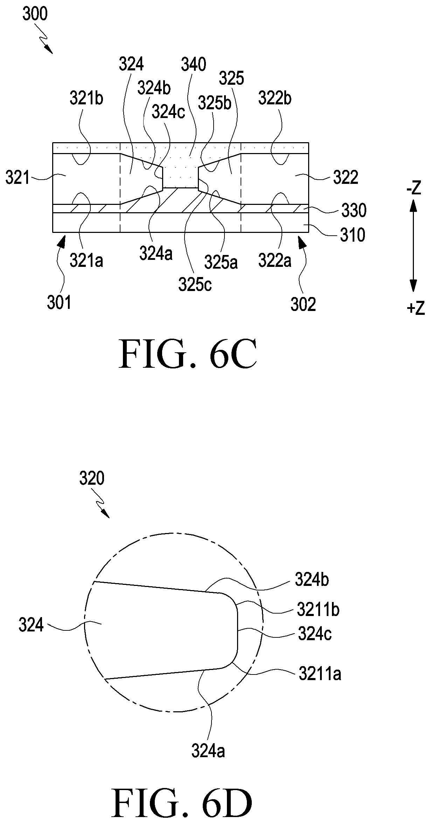

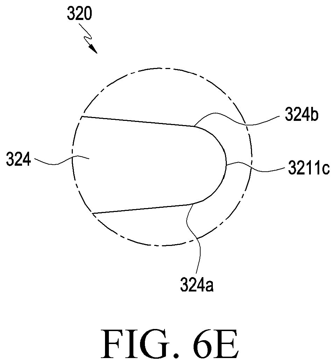

According to an embodiment, the first housing 210 may be connected to be rotatable with respect to the second housing 220. For example, the first housing 210 may be connected to be rotatable with respect to the second housing 220 using a hinge structure (e.g., a hinge structure 280 in FIG. 4). The electronic device 200 may be changed to the folded state (e.g., FIG. 2) or the unfolded state (e.g., FIG. 3). In the electronic device 200, the first front surface 210a may face the second front surface 220a in the folded state, and the first front surface 210a and the second front surface 220a may face in the same direction in the unfolded state. For example, the first front surface 210a and the second front surface 220a may be located on substantially the same plane in the unfolded state. According to an embodiment, the second housing 220 may provide relative movement with respect to the first housing 210. According to an embodiment, the first housing 210 may receive force for rotation with respect to the second housing 202 using an elastic member (e.g., an elastic member 330 in FIG. 6).

According to an embodiment, the first housing 210 and the second housing 220 may be disposed on both sides of a folding axis A and symmetrical in shape with respect to the folding axis A as a whole. An angle between the first housing 210 and the second housing 220 may be changed depending on whether the electronic device 200 is in the unfolded state, the folded state, or an intermediate state between the unfolded state and the folded state.

According to an embodiment, the electronic device 200 may include a hinge cover 240. At least part of the hinge cover 240 may be disposed between the first housing 210 and the second housing 220. According to an embodiment, the hinge cover 240 may be covered by parts of the first housing 210 and the second housing 220 or exposed to the outside of the electronic device 200 according to the state of the electronic device 200. According to an embodiment, the hinge cover 240 may protect the hinge structure (e.g., the hinge structure 280 in FIG. 4) and/or the elastic member (e.g., the elastic member 330 in FIG. 6) of the electronic device 200 from external impact. According to an embodiment, the hinge cover 240 may be referred to as a hinge housing.

According to an embodiment, as illustrated in FIG. 2, when the electronic device 200 is in the unfolded state, the hinge cover 240 may be covered by the first housing 210 and the second housing 220 without being exposed. In another example, as illustrated in FIG. 3, when the electronic device 200 is in the folded state (e.g., a fully folded state), the hinge cover 240 may be exposed to the outside from between the first housing 210 and the second housing 220. In another example, in the intermediate state where the first housing 210 and the second housing 220 are folded with a certain angle, the hinge cover 240 may be partially exposed to the outside from between the first housing 210 and the second housing 220. In this case, however, an exposed area may be smaller than in the fully folded state. In an embodiment, the hinge cover 240 may include a curved surface.

According to an embodiment, the display 230 may visually provide information to the outside of the electronic device 200 (e.g., a user). The display 230 may include, for example, a hologram device or a projector and a control circuit for controlling the corresponding device. According to an embodiment, the display 230 may include a touch sensor configured to detect a touch or a pressure sensor configured to measure the strength of force generated by the touch.

According to an embodiment, the display 230 may refer to a display having at least a partial area deformable into a flat or curved surface. For example, the display 230 may be formed to be changed in response to relative movement of the second housing 220 with respect to the first housing 210. According to an embodiment, the display 230 may include a folding area 233, a first display area 231 disposed on one side (e.g., above (+Y direction)) of the folding area 233, and a second display area 232 disposed on the other side (e.g., below (-Y direction)) of the folding area 233. According to an embodiment, the folding area 233 may be located above the hinge structure (e.g., the hinge structure 280 in FIG. 4) and/or the elastic member (e.g., the elastic member 330 in FIG. 6) in the unfolded state (e.g., FIG. 2) of the electronic device 200. For example, at least part of the folding area 233 may face the hinge structure 280. According to an embodiment, the folding area 233 may be referred to as part of the display 230, which is at least partially bent based on a state change (e.g., folded or unfolded) of the electronic device 200. According to an embodiment, the first display area 231 may be disposed on the first housing 210, and the second display area 232 may be disposed on the second housing 220. According to an embodiment, the display 230 may be accommodated in the first housing 210 and the second housing 220.

However, the area division of the display 230 illustrated in FIG. 2 is exemplary, and the display 230 may be divided into a plurality of areas (e.g., four or more or two areas) according to a structure or function.

In addition, while the display 230 is divided into areas by the folding area 233 extending in parallel to an X axis or the folding axis A in the embodiment illustrated in FIG. 2, the display 230 may be divided into areas by another folding area (e.g., a folding area parallel to a Y axis) or another folding axis (e.g., a folding axis parallel to the Y axis) in another embodiment. According to an embodiment, the display 230 may be coupled to or disposed adjacent to a touch sensing circuit, a pressure sensor capable of measuring the intensity (pressure) of a touch, and/or a digitizer configured to detect a magnetic field type stylus pen.

According to an embodiment, the electronic device 200 may include a rear display 234. The rear display 234 may face in a direction different from that of the display 230. For example, the display 230 may be visually exposed through the front surface (e.g., the first front surface 210a and/or the second front surface 220a) of the electronic device 200, and the rear display 234 may be visually exposed through the rear surface (e.g., the first rear surface 210b) of the electronic device 200.

According to an embodiment, the electronic device 200 may include at least one camera module 204 and 206 and a flash 208. According to an embodiment, the electronic device 200 may include a front camera module 204 exposed through the front surface (e.g., the first front surface 210a) and/or a rear camera module 206 exposed through the rear surface (e.g., the first rear surface 220b). The camera modules 204 and 206 may include one or more lenses, an image sensor, a flash, and/or an image signal processor. The flash 208 may include a light emitting diode or a xenon lamp. In a certain embodiment, two or more lenses (an infrared camera, a wide-angle lens, and a telephoto lens) and image sensors may be disposed on one surface of the electronic device 200. The configuration of the front camera module 204 and/or the rear camera module 206 may be wholly or partially identical to that of the camera module 180 in FIG. 1.

FIG. 4 is an exploded perspective view illustrating an electronic device according to an embodiment of the disclosure.

Referring to FIG. 4, the electronic device 200 may include the first housing 210, the second housing 220, the display 230, the hinge cover 240, the battery 250, a PCB 260, a flexible printed circuit board (FPCB) 270, and the hinge structure 280. The configurations of the first housing 210, the second housing 220, the display 230, and the hinge cover 240 in FIGS. 3 and 4 may be wholly or partially identical to those of the first housing 210, the second housing 220, the display 230, and the hinge cover 240 in FIG. 2 and/or FIG. 3.

According to an embodiment, the electronic device 200 may include a first support member 212 and a second support member 222. For example, the first housing 210 may include the first support member 212, and the second housing 220 may include the second support member 222. According to an embodiment, the first support member 212 and/or the second support member 222 may support components (e.g., the display 230, the battery 250, and the PCB 260) of the electronic device 200.

According to an embodiment, the first support member 212 and/or the second support member 222 may be formed of a metal material and/or a non-metal (e.g., polymer) material. According to an embodiment, the first support member 212 may be disposed between the display 230 and the battery 250. For example, the display 230 may be coupled to one surface of the first support member 212, and the battery 250 and the PCB 260 may be disposed on the other surface of the first support member 212.

According to an embodiment, the electronic device 200 may include a first protection member 214 and a second protection member 224. For example, the first housing 210 may include the first protection member 214, and the second housing 220 may include the second protection member 224. According to an embodiment, the protection members 214 and 224 may protect the display 230 from external impact. For example, the first protection member 214 may at least partially surround a part (e.g., the first display area 231 in FIG. 2) of the display 230, and the second protection member 224 may at least partially surround another part (e.g., the second display area 232 in FIG. 2) of the display 230. According to an embodiment, the first protection member 214 may be referred to as a first deco member, and the second protection member 214 may be referred to as a second deco member.

According to an embodiment, the housings 210 and 220 may include a first rear plate 216 and a second rear plate 226. For example, the first housing 210 may include the first rear plate 216 connected to the first support member 212, and the second housing 220 may include the second rear plate 226 connected to the second support member 222. According to an embodiment, the rear plates 216 and 226 may form part of the exterior of the electronic device 200. For example, the first rear plate 216 may form the first rear surface (e.g., the first rear surface 210b in FIG. 2), and the second rear plate 226 may form the second rear surface (e.g., the second rear surface 220b in FIG. 2). According to an embodiment, a first battery 252 and a first printed circuit board 262 may be disposed between the first support member 212 and the first rear plate 216, and a second battery 254 and a second printed circuit board 264 may be disposed between the second support member 222 and the second rear plate 226.

According to an embodiment, the hinge cover 240 may accommodate at least part of the hinge structure 280. For example, the hinge cover 240 may include an accommodation groove 242 to accommodate the hinge structure 280 therein. According to an embodiment, the hinge cover 240 may be coupled to the hinge structure 280. According to an embodiment, at least part of the hinge cover 240 may be located between the hinge structure 280 and the housings 210 and 220 in the unfolded state of the electronic device 200. According to an embodiment, the hinge cover 240 may guide movement of the housings 210 and 220. For example, each of the first housing 210 and the second housing 220 may rotate with respect to the hinge cover 240, while being connected to the hinge cover 240.

According to an embodiment, the battery 250, which is a device to supply power to at least one component of the electronic device 200, may include a non-rechargeable primary battery, a rechargeable secondary battery, or a fuel cell. The battery 250 may be integrally disposed inside the electronic device 200 or detachably from the electronic device 200. According to an embodiment, the battery 250 may include the first battery 252 disposed within the first housing 210 and the second battery 254 disposed within the second housing 220. For example, the first battery 252 may be disposed on the first support member 212, and the second battery 254 may be disposed on the second support member 222.

According to an embodiment, a processor (e.g., the processor 120 in FIG. 1), memory (e.g., the memory 130 in FIG. 1), and/or an interface (e.g., the interface 177 in FIG. 1) may be mounted on the PCB 260. According to an embodiment, the PCB 260 may include the first printed circuit board 262 disposed within the first housing 210 and the second printed circuit board 264 disposed within the second housing 220.

According to an embodiment, the FPCB 270 may electrically connect a component (e.g., the first printed circuit board 262) located in the first housing 210 to a component (e.g., the second printed circuit board 264) located in the second housing 220. According to an embodiment, at least part of the FPCB 270 may cross the hinge cover 240 and/or the hinge structure 280. For example, a part of the FPCB 270 may be disposed within the first housing 210, and another part thereof may be disposed within the second housing 220. According to an embodiment, the FPCB 270 may include a first FPCB 272 connected to an antenna and a second FPCB 274 connected to the display 230.

According to an embodiment, the hinge structure 280 may include a plurality of hinge structures 280-1 and 280-2 arranged in parallel. For example, the hinge structure 280 may include a first hinge structure 280-1 and a second hinge structure 280-2 spaced apart from the first hinge structure 280-1. According to an embodiment, the first hinge structure 280-1 may be symmetrical to the second hinge structure 280-2 with respect to a longitudinal direction (e.g., a Y-axis direction) of the electronic device 200. According to an embodiment, the hinge structure 280 may be omitted according to an embodiment of the electronic device 200.

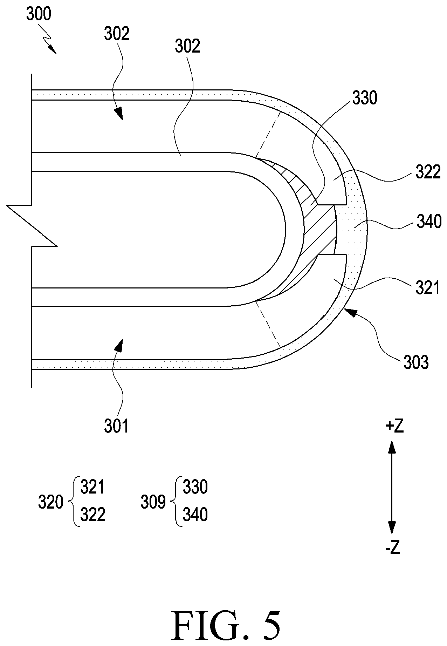

FIG. 5 is a cross-sectional view illustrating a folded cover window according to an embodiment of the disclosure. FIGS. 6A to 6C are diagrams referred to for describing a process of manufacturing a cover window according to an embodiment of the disclosure. FIGS. 6D and 6E are diagrams referred to for describing the shape of a glass according to an embodiment of the disclosure.

Referring to FIG. 5, FIG. 6A, FIG. 6B, and/or FIG. 6C, a cover window 300 may include a protective layer 310, a glass 320, a first adhesive layer 330, and a second adhesive layer 340.

According to an embodiment, the cover window 300 may protect a display (e.g., the display 230 in FIG. 4). For example, the cover window 300 may be disposed on the display 230. The cover window 300 may be a substantially transparent protective member covering at least a portion of the display 230.

According to an embodiment, the cover window 300 may be assembled or attached to the display 230. For example, the cover window 300 and the display 230 may be coupled to each other, and a component in which the cover window 300 and the display 230 are coupled may be referred to as a display assembly.

According to an embodiment, the cover window 300 may be foldable. For example, when the electronic device (e.g., the electronic device 200 in FIG. 2) is changed to the unfolded state (e.g., FIG. 2) or the folded state (e.g., FIG. 3), the cover window 300 may be folded together with a housing (e.g., the housing 202 in FIG. 2) of an electronic device (e.g., the electronic device 200 in FIG. 2).

According to an embodiment, the cover window 300 may include a first flat area 301, a second flat area 302, and a bending area 303. The first flat area 301 may be a portion of the cover window 300 located on a first display area (e.g., the first display area 231 in FIG. 2). The second flat area 302 may be a portion of the cover window 300 located on a second display area (e.g., the second display area 232 in FIG. 2). The bending area 303 may be a portion of the cover window 300 located on a folding area (e.g., the folding area 233 in FIG. 2). The bending area 303 may be located between the first flat area 301 and the second flat area 302. **In** an embodiment, the first flat area 301 may be disposed on a first housing (e.g., the first housing 210 in FIG. 2), and the second flat area 302 may be disposed on a second housing (e.g., the second housing 220 in FIG. 2). **In an** embodiment, the cover window 300 may be referred to as a window, a protective cover, a flexible window member, or a foldable window member.

According to an embodiment, the cover window 300 may include the protective layer 310 to reduce damage (e.g., scratches) of the display 230. According to an embodiment, the protective layer 310 may be foldable together with the cover window 300. According to an embodiment, the protective layer 310 may be ultra-thin glass (UTG) or flexible thin glass (FTG). For example, the thickness of the protective layer 310 may range from about 30µm to 50µm. For example, the protective layer 310 may be referred to as a glass film. According to an embodiment, since the protective layer 310 is made of glass, the size of a line or folding mark that may occur in the bending area 303 of the cover window 300 may be reduced. According to an embodiment, the protective layer 310 may be made of resin. For example, the protective layer 310 may be a polyimide PI film.

According to an embodiment, the glass 320 may be formed to be bent based on the deformation of the display 230. For example, the glass 320 may include a plurality of glasses 321 and 322 at least partially spaced apart from each other. **In** an embodiment, the glass 320 may include a first glass 321 and a second glass 322 spaced apart from the first glass 321. For example, the first glass 321 may be spaced apart from the second glass 322 by a gap 323 therebetween. According to an embodiment, at least a portion of the first glass 321 may be located in the first flat area 301, and at least a portion of the second glass 322 may be located in the second flat area 302. For example, a first end 324 of the first glass 321 may be located in the bending area 303, and another portion of the first glass 321 may be located in the first flat area 301, not in the second flat area 302. A second end 325 of the second glass 322 may be located in the bending area 303, and another portion of the second glass 322 may be located in the second flat area 302, not in the first flat area 301. According to an embodiment, the thickness of the glass 320 may be larger than the thickness of the protective layer 310. For example, the thickness of the glass 320 may be about 60µm.

Referring to FIGS. 6A to 6E, the glass 320 may have various shapes. However, the shape of the glass 320 is optional. For example, in addition to the shape of the glass 320 disclosed in FIG. 6B, FIG. 6C, FIG. 6D, and/or FIG. 6E, a glass 320 having a shape that is foldable and prevented from being broken may be applied to the cover window 300 of the disclosure.

According to an embodiment (e.g., FIGS. 6B and 6C), the glass 320 may include the ends 324 and 325 having a chamfered shape. For example, the first glass 321 may include the first end 324 having a chamfered shape. The second glass 322 may include the second end 325 having a chamfered shape. According to an embodiment, the first glass 321 may include a first front surface 321a facing the protective layer 310 and a first rear surface 321b opposite to the first front surface 321a. The first end 324 may be a portion of a side surface of the first glass 321 extending from the first front surface 321a to the first rear surface 321b. The first end 324 may include a first end area 324a extending from the first front surface 321a and inclined with respect to the first front surface 321a, a second end area 324b extending from the first rear surface 321b and inclined with respect to the second rear surface 321b, and a third end area 324c located between the first end area 324a and the second end area 324b. In an embodiment, the second glass 322 may include a second front surface 322a facing the protective layer 310 and a second rear surface 322b opposite to the second front surface 322a. The second end 325 may be a portion of a side surface of the second glass 322 extending from the second front surface 322a to the second rear surface 322b. The second end 325 may include a fourth end area 325a extending from the second front surface 322a and inclined with respect to the second front surface 322a, a fifth end area 325b extending from the second rear surface 322b and inclined with respect to the second rear surface 322b, and a sixth end area 325c located between the fourth end area 325a and the fifth end area 325b.

According to an embodiment (e.g., FIG. 6D), the glass 320 (e.g., the first glass 321 in FIG. 6C) may include the first end 324 formed at least partially as a curved surface. For example, the first end 324 may include the first end area 324a extending from the first front surface (e.g., the first front surface 321a in FIG. 6C), the second end area 324b extending from the first rear surface (e.g., the first rear surface 321b in FIG. 6C), and the third end area 324c facing the second glass (e.g., the second glass 322 in FIG. 6C). The first end 324 may include a first curved surface 3211a located between the first end area 324a and the third end area 324c, and a second curved surface 3211b located between the second end area 324b and the third end area 324c. The first curved surface 3211a and the second curved surface 3211b may have a radius of curvature of 1µm or more. According to an embodiment, the first curved surface 3211a may be a surface formed by cutting a portion of the first end area 324a or the third end area 324c. The second curved surface 3211b may be a surface formed by cutting a portion of the second end area 324b or the third end area 324c.

According to an embodiment (e.g., FIG. 6E), the glass 320 (e.g., the first glass 321 in FIG. 6c) may include the first end 324 formed at least partially as a curved surface. The first end 324 may include the first end area 324a extending from the first front surface (e.g., the first front surface 321a in FIG. 6C) and the second end area 324b extending from the first rear surface (e.g., the first rear surface 321b in FIG. 6C). According to an embodiment, a portion of the first end 324 facing the second end (e.g., the second end 325 in FIG. 6C) of the second glass (e.g., the second glass 322 in FIG. 6C) may be formed as a curved surface. For example, the first end 324 may include a third curved surface 3211c located between the first end area 324a and the second end area 324b.

In the disclosure, the description of the first end 324 may be applied to the second end 325. For example, the first glass 321 may be formed substantially symmetrically with the second glass 322. The shape of the first end 324 may be substantially symmetrical with the shape of the second end 325.

According to an embodiment, an adhesive layer 309 may connect or contact the glass 320 to the protective layer 310. According to an embodiment, at least a portion of the adhesive layer 309 may be disposed between the glass 320 and the protective layer 310. According to an embodiment, the adhesive layer 309 may be applied in a coating liquid state, applied onto the protective layer 310, and disposed on the protective layer 310. According to an embodiment, the glass 320 may be coupled to the protective layer 310 using the adhesive layer 309. For example, the glass 320 may be connected to the protective layer 310 using the first adhesive layer 330. According to an embodiment, the glass 320 may be coupled to the display 230 using the adhesive layer 309. For example, the glass 320 may be connected to the display 230 using the second adhesive layer 340.

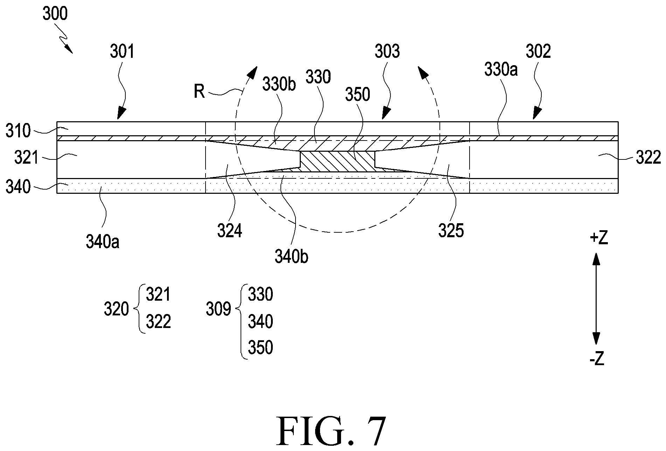

According to an embodiment, the adhesive layer 309 may allow at least a portion of light generated from the display 230 to pass through. For example, the adhesive layer 309 may be substantially transparent. According to an embodiment, the adhesive layer 309 may include an optically clear resin (OCR). For example, the first adhesive layer 330, the second adhesive layer 340, and a third adhesive layer (e.g., a third adhesive layer 350 in FIG. 7) may include an OCR.

In an embodiment, the adhesive layers 330 and 340 may have different hardnesses in portions thereof. For example, the hardness of the adhesive layers 330 and 340 may be greater as they are located further under (e.g., in the -Z direction) the cover window 300. According to an embodiment, the adhesive layer 309 may include the first adhesive layer 330 at least partially located between the protective layer 310 and the glass 320. The adhesive layer 309 may include the second adhesive layer 340 at least partially located between the glass 320 and the display (e.g., the display 230 in FIG. 3). A second hardness of the second adhesive layer 340 may be greater than a first hardness of the first adhesive layer 330.

According to an embodiment, the first adhesive layer 330 may be referred to as a low-viscosity adhesive layer. For example, the viscosity of the first adhesive layer 330 may be about 1000 centi-Poises (cP).

According to an embodiment, the cover window 300 may be formed by stacking each component. For example, referring to FIG. 6A, the first adhesive layer 330 may be applied under the protective layer 310 (in the -Z direction). Referring to FIG. 6B, the glass 320 may be disposed on the first adhesive layer 330. For example, the first glass 321 and the second glass 322 may be disposed on the first adhesive layer 330, spaced apart from each other. The gap 393 may be located between the first glass 321 and the second glass 322. The gap 393 may be referred to as an empty space. With the glass 320 positioned on the first adhesive layer 330 using a jig, the cover window 300 may be primarily cured. Referring to FIG. 6C, the second adhesive layer 340 may be applied on the glass 320 and/or the first adhesive layer 330. According to an embodiment, at least a portion of the second adhesive layer 340 may be located in the bending area 303 of the cover window 300. According to an embodiment, at least a portion of the second adhesive layer 340 may be located between the first end 324 of the first glass 321 and the second end 325 of the second glass 322. With the second adhesive layer 340 applied on the glass 320, the cover window 300 may be secondarily cured.

FIG. 7 is a cross-sectional view illustrating a cover window according to an embodiment of the disclosure.

Referring to FIG. 7, the cover window 300 may include the first adhesive layer 330, the second adhesive layer 340, and the third adhesive layer 330. The configurations of the cover window 300, the protective layer 310, the glass 320, the first adhesive layer 330, and the second adhesive layer 340 in FIG. 7 may be wholly or partially identical to the configuration of the cover window 300 in FIGS. 5 and 6D.

According to an embodiment, the structure of the adhesive layer 309 in FIG. 7 may be at least partially identical to the configuration of the adhesive layer 309 in FIG. 5. For example, the adhesive layer 309 may include the first adhesive layer 330 at least partially located between the protective layer 310 and the glass 320, and the second adhesive layer 340 at least partially located between the glass 320 and the display (e.g., the display 230 in FIG. 4).

According to an embodiment, at least a portion of the first adhesive layer 330 may protrude. For example, the first adhesive layer 330 may be formed to correspond to the shape of the glass 320. According to an embodiment, the first adhesive layer 330 may include a first flat portion 330a and a first protruding portion 330b. The first flat portion 330a may be located on the front surface (e.g., the first front surface 321a and the second front surface 322a in FIG. 6C) of the glass 320 (e.g., in the +Z direction). The first protruding portion 330b may be a portion of the first adhesive layer 330 that protrudes or extends from the first flat portion 330a. The first protruding portion 330b may be located on the first end 324 of the first glass 321, the second end 325 of the second glass 322, and the third adhesive layer 350 (in the +Z direction).

According to an embodiment, at least a portion of the second adhesive layer 340 may protrude. For example, the second adhesive layer 330 may be formed to correspond to the shape of the glass 320. According to an embodiment, the second adhesive layer 340 may include a second flat portion 340a and a second protruding portion 340b. The second flat portion 340a may be located under the rear surface (e.g., the first rear surface 321b and the second rear surface 322b in FIG. 6C) of the glass 320 (in the -Z direction). The second protruding portion 340b may be a portion of the second adhesive layer 340 that protrudes or extends from the second flat portion 340a. The second protruding portion 340b may be located under the first end 324 of the first glass 321, the second end 325 of the second glass 322, and the third adhesive layer 350 (in the -Z direction).

According to an embodiment, the adhesive layer 309 may include the third adhesive layer 350 located between the first adhesive layer 330 and the second adhesive layer 340. According to an embodiment, the third adhesive layer 350 may be surrounded by the first adhesive layer 330, the second adhesive layer 340, the first glass 321, and the second glass 322. For example, the third adhesive layer 350 may be located between the first end 314 and the second end 324. According to an embodiment, the configuration of the third adhesive layer 350 in FIG. 7 may be wholly or partially identical to the configuration of the second area 33b of the first adhesive layer 330 in FIG. 6D.

According to an embodiment, the adhesive layer 309 may have different hardnesses in portions. For example, the hardness of the adhesive layer 309 may be greater as it is located further under the cover window 300 (e.g., in the -Z direction). For example, the hardness of the adhesive layer 309 may be gradually increased as it is located closer to the display 230. According to an embodiment, the cover window 300 may be folded along a bending direction R. As the hardness of the adhesive layer 309 decreases upward in the +Z direction of the cover window 300, the cover window 300 may be folded while maintaining the degree of protection of the display 230 of the cover window 300.

According to an embodiment, the first adhesive layer 330 may have a first hardness. The second adhesive layer 340 may have a second hardness greater than the first hardness. The third adhesive layer 350 may have a third hardness greater than the first hardness and less than the second hardness. For example, the first hardness may range from a Shore hardness greater than 0 to a Shore hardness less than 10. The second hardness may range from a Shore hardness greater than 10 to a Shore hardness less than 15. The third hardness may range from a Shore hardness greater than 15 to a Shore hardness less than 20. In the disclosure, a Shore hardness may mean a hardness value measured using a Shore A type indenter. For example, the hardness value of the adhesive layer 309 in the disclosure may mean a hardness value measured using a GS-709G hardness tester from TECLOCK.

The hardness value of the first adhesive layer 330, the second adhesive layer 340, and/or the third adhesive layer 350 disclosed herein may be optional. For example, according to an embodiment, at least two of the first adhesive layer 330, the second adhesive layer 340, or the third adhesive layer 350 may have the same hardness. According to an embodiment (e.g., FIG. 6), the first adhesive layer 330 and the third adhesive layer 350 may have the first hardness, and the second adhesive layer 350 may have the third hardness. According to an embodiment, the first adhesive layer 330 may have the first hardness, and the second adhesive layer 340 and the third adhesive layer 350 may have the third hardness. According to an embodiment, the third adhesive layer 350 may have a greatest hardness.

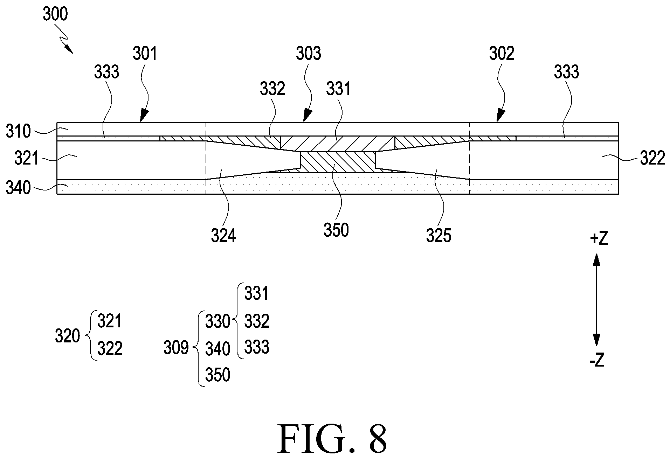

FIG. 8 is a cross-sectional view illustrating a cover window according to an embodiment of the disclosure.

Referring to FIG. 8, the cover window 300 may include the protective layer 310, the glass 320, the first adhesive layer 330, the second adhesive layer 340, and the third adhesive layer 350. The configurations of the protective layer 310, the glass 320, the first adhesive layer 330, the second adhesive layer 340, and the third adhesive layer 350 in FIG. 8 may be wholly or partially identical to the configurations of the protective layer 310, the glass 320, the first adhesive layer 330, the second adhesive layer 340, and the third adhesive layer 350 in FIG. 7.

According to an embodiment, the adhesive layer 309 may have different hardnesses in portions thereof. For example, the adhesive layer 309 may have a greater hardness as it is located further downward (e.g., in the -Z direction). For example, the first adhesive layer 330 may have a first hardness. The second adhesive layer 340 may have a second hardness greater than the first hardness. The third adhesive layer 350 may have a third hardness greater than the first hardness and less than the second hardness.

According to an embodiment, the first adhesive layer 330 may have a greater hardness as it is farther from a folding axis (e.g., the folding axis A in FIG. 2). For example, the first adhesive layer 330 may include a first portion 331, a second portion 332, and a third portion 333 having different hardnesses.

According to an embodiment, the first portion 331 may be located substantially at the center of the cover window 300. For example, the first portion 331 may be located to correspond to the folding axis (e.g., the folding axis A in FIG. 2) of the electronic device (e.g., the electronic device 200 in FIG. 2). The first portion 331 may be located above a folding area (e.g., the folding area 233 in FIG. 2) of the display (e.g., the display 230 in FIG. 2). According to an embodiment, the first portion 331 may be located at least partially on the second layer 350 (e.g., in the +Z direction).

According to an embodiment, the second portion 332 may be located inside the cover window 300. For example, the second portion 332 may surround at least a portion of the first portion 331. According to an embodiment, at least a portion of the second portion 332 may be located on the first end 324 of the first glass 321 and the second end 325 of the second glass 322 (e.g., in the +Z direction). In an embodiment, the second portion 332 may be located between the first portion 331 and the third portion 333.

According to an embodiment, the third portion 333 may be located substantially at an edge of the cover window 300. For example, the third portion 333 may surround at least a portion of the second portion 332. According to an embodiment, at least a portion of the third portion 333 may be located on at least a portion of the first glass 321 and the second glass 322 (e.g., in the +Z direction).

According to an embodiment, the first portion 331 may have a fourth hardness. The second portion 332 may have a fifth hardness greater than the fourth hardness. The third portion 333 may have a sixth hardness greater than the fifth hardness. According to an embodiment, the fourth hardness may range from a Shore hardness greater than 0 to a Shore hardness less than 10. The fifth hardness may range from a Shore hardness greater than 10 to a Shore hardness less than 15. The sixth hardness may range from a Shore hardness greater than 15 to a Shore hardness less than 20. For example, the fourth hardness of the first portion 331 may be substantially equal to the first hardness of the first adhesive layer 330 of FIG. 7. The fifth hardness of the second portion 332 may be substantially equal to the third hardness of the third adhesive layer 350 of FIG. 7. The sixth hardness of the third portion 333 may be substantially equal to the second hardness of the second adhesive layer 340 of FIG. 7.

According to an embodiment, as adhesives having different hardnesses are mixed in the first adhesive layer 330, the first adhesive layer 330 may have a stepwise-changing hardness. For example, the hardness of the first adhesive layer 330 may be differentiated or changed stepwise.

According to an embodiment, the structure of the cover window 300 in FIG. 8 may be used together with the structure of the foregoing embodiment (e.g., the cover window 300 in FIG. 7).

While the first adhesive layer 330 has been described as having three portions (e.g., the first portion 331, the second portion 332, and the third portion 333) with different hardnesses in the disclosure, the disclosure is not limited thereto. For example, the first adhesive layer 330 may have two portions with different hardnesses. For example, the first adhesive layer 330 may have four or more portions with different hardnesses.

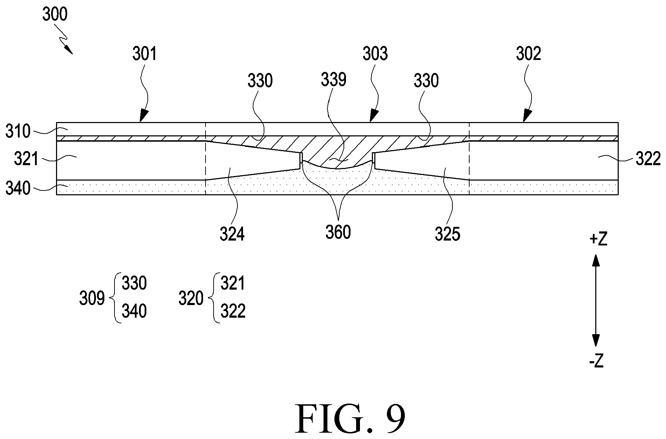

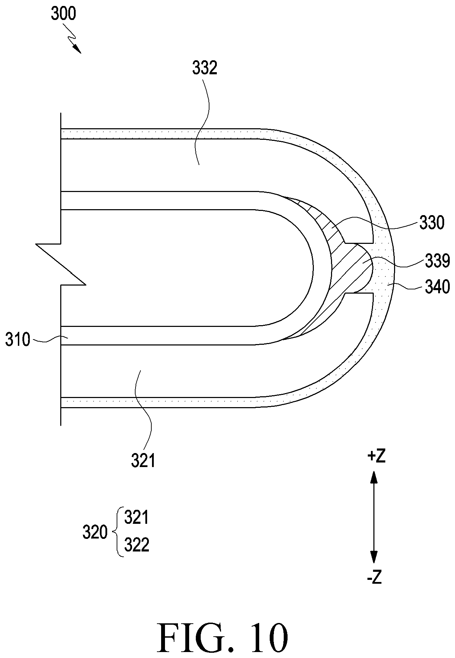

FIG. 9 is a cross-sectional view illustrating a cover window according to an embodiment of the disclosure. FIG. 10 is a cross-sectional view illustrating a folded cover window according to an embodiment of the disclosure.

Referring to FIGS. 9 and 10, the cover window 300 may include the protective layer 310, the glass 320, the first adhesive layer 330, and the second adhesive layer 340. The configurations of the protective layer 310, the glass 320, the first adhesive layer 330, and the second adhesive layer 340 in FIGS. 9 and 10 may be wholly or partially identical to the configurations of the protective layer 310, the glass 320, the first adhesive layer 330, and the second adhesive layer 340 in FIG. 7.

According to an embodiment, the cover window 300 may include a cushion area 339 for enhancing the folding performance of the cover window 300. The cushion area 339 may increase the ratio of the first adhesive layer 330 having a relatively low strength. For example, the hardness of the adhesive layer 309 corresponding to the folding axis (e.g., the folding axis A in FIG. 2) of the electronic device (e.g., the electronic device 200 in FIG. 2) may be reduced, thereby increasing a degree to which the cover window 300 and/or the electronic device 200 is folded. According to an embodiment, the cushion area 339 may have a water droplet shape. For example, the cushion area 390 may be referred to as an embossed structure.

According to an embodiment, the cover window 300 may include a water-repellent coating layer 360. The cushion area 339 may be formed using the water-repellent coating layer 360. For example, the water-repellent coating layer 360 may be coated on a side portion (e.g., the third end area 324c in FIG. 6C) of the first glass 321 and a side portion (e.g., the sixth end area 325c in FIG. 6C) of the second glass 322. According to an embodiment, the water-repellent coating layer 360 may be located between the first adhesive layer 330 and the ends (e.g., the first end 324 and the second end 325 in FIG. 6C) of the glass 320. The first adhesive layer 330 may protrude further downward from the cover window 300 due to the water-repellent coating layer 360. According to an embodiment, the water-repellent coating layer 360 may be located between the first adhesive layer 330 and the second adhesive layer 340. According to an embodiment, the cushion area 339 may be referred to as a portion of the first adhesive layer 330. The cushion area 339 may protrude from the first adhesive layer 330 toward the second adhesive layer 340. For example, the cushion area 339 in FIGS. 9 and 10 may be wholly or partially identical to the configuration of the first protruding portion 330b in FIG. 7.

According to an embodiment, the cushion area 339 may be located between the first glass 321 and the second glass 322. For example, the cushion area 339 may be located between the first end 324 of the first glass 321 and the second end 325 of the second glass 322. According to an embodiment, the cushion area 339 may be located on the second adhesive layer 340 (e.g., in the +Z direction).

An electronic device (e.g., a portable terminal) may include a display having a flat surface or a flat surface and curved surface. The electronic device including the display may have limitations in implementing a screen larger than the size of the electronic device due to the fixed structure of the display. Therefore, an electronic device including a foldable display is under study.

The electronic device including the foldable display requires a cover window to reduce damage to the display. However, as the thickness of the cover window increases, the volume of the electronic device increases, and a force required to fold the display increases, which may reduce user convenience. When the thickness of the cover window decreases, the display may not be effectively protected from external impact.

According to an embodiment of the disclosure, an electronic device capable of protecting a display and reducing a force required to fold the display may be provided.

However, the problem to be solved in the disclosure is not limited to the problem mentioned above, and may be expanded in various ways without departing from the scope and spirit of the disclosure.

According to an embodiment of the disclosure, an electronic device (e.g., the electronic device 200 in FIG. 2) may include a housing (e.g., the housing 202 in FIG. 2) including a first housing (e.g., the first housing 210 in FIG. 2) and a second housing (e.g., the second housing 220 in FIG. 2) rotatably connected to the first housing, a foldable display (e.g., the display 230 in FIG. 2) connected to the first housing and the second housing, and a cover window (e.g., the cover window 300 in FIG. 7) protecting the foldable display, and including a first flat area (e.g., the first flat area 301 in FIG. 7) connected to the first housing, a second flat area (e.g., the second flat area 302 in FIG. 7) connected to the second housing, and a bending area (e.g., the bending area 303 in FIG. 7) located between the first flat area and the second flat area. The cover window may include a protective layer (e.g., the protective layer 310 in FIG. 7) forming at least a portion of an outer surface of the cover window, a glass (e.g., the glass 320 in FIG. 7) including a first glass (e.g., the first glass 321 in FIG. 7) at least partially located in the first flat area and a second glass (e.g., the second glass 322 in FIG. 7) spaced apart from the first glass and at least partially located in the second flat area, a first adhesive layer (e.g., the first adhesive layer 330 in FIG. 7) at least partially located between the protective layer and the glass and having a first hardness, a second adhesive layer (e.g., the second adhesive layer 340 in FIG. 7) at least partially located between the glass and the display and having a second hardness, and a third adhesive layer (e.g., the third adhesive layer 350 in FIG. 7) surrounded by the glass, the first adhesive layer, and the second adhesive layer and having a third hardness greater than the first hardness and less than the second hardness. The first adhesive layer may absorb at least a portion of impact transmitted from the outside. The cover window may protect the display due to the first adhesive layer. Since the glass is connected to the protective layer using the first adhesive layer, lifting or separation of the glass may be reduced.

According to an embodiment, the first glass may include a first end (e.g., the first end 324 in FIG. 7) facing the second glass and having a chamfered shape. The second glass may include a second end (e.g., the second end 325 in FIG. 7) facing the first glass and having a chamfered shape.

According to an embodiment, the third adhesive layer may be located between the first end and the second end.

According to an embodiment, the glass may include a front surface (e.g., the first front surface 321a and the second front surface 322a in FIG. 6C) facing the protective layer and a rear surface (e.g., the first rear surface 321b and the second rear surface 322b in FIG. 6C) opposite to the front surface and facing the foldable display. The first adhesive layer may include a first flat portion (e.g., the first flat portion 330a in FIG. 7) located above the front surface, and a first protruding portion (e.g., the first protruding portion 330b in FIG. 7) extending from the first flat portion and located above the first end, the second end, and the third adhesive layer. The second adhesive layer may include a second flat portion (e.g., the second flat portion 340a in FIG. 7) located under the rear surface, and a second protruding portion (e.g., the second protruding portion 340b in FIG. 7) extending from the second flat portion and located under the first end, the second end, and the third adhesive layer.

According to an embodiment, the foldable display may include a first display area (e.g., the first display area 231 in FIG. 2) connected to the first housing, a second display area (e.g., the second display area 232 in FIG. 2) connected to the second housing, and a folding area (e.g., the folding area 233 in FIG. 2) located between the first display area and the second display area.

According to an embodiment, the first adhesive layer may include a first portion (e.g., the first portion 331 in FIG. 8) located above the folding area, a second portion (e.g., the second portion 332 in FIG. 8) surrounding at least a portion of the first portion, and a third portion (e.g., the third portion 333 in FIG. 8) surrounding at least a portion of the second portion. A fourth hardness of the first portion, a fifth hardness of the second portion, and a sixth hardness of the third portion may be different.

According to an embodiment, the fifth hardness may be greater than the fourth hardness, and the sixth hardness may be greater than the fifth hardness.

According to an embodiment, the first flat area may be disposed on the first display area, the second flat area may be disposed on the second display area, and the bending area may be disposed on the folding area.

According to an embodiment, the first adhesive layer may include a cushion area (e.g., the cushion area 339 in FIG. 9) located between the first glass and the second glass.

According to an embodiment, the cover window may include a water-repellent coating layer (e.g., the water-repellent coating layer 360 in FIG. 9) located between the first adhesive layer and the second adhesive layer.

According to an embodiment, a thickness of the glass may be thicker than a thickness of the protective layer.

According to an embodiment, the first adhesive layer, the second adhesive layer, and the third adhesive layer may include an OCR.

According to an embodiment, the first hardness may range from a Shore hardness of 0 to a Shore hardness of 10, the second hardness may range from the Shore hardness of 10 to a Shore hardness of 15, and the third hardness may range from a Shore hardness of 16 to a Shore hardness of 20.

According to an embodiment, a hardness of an adhesive layer (e.g., the adhesive layer 309 in FIG. 7) including the first adhesive layer, the second adhesive layer, and the third adhesive layer may gradually increase closer to the foldable display.

According to an embodiment, the protective layer may include UTG or a polyimide film.

According to an embodiment of the disclosure, a cover window (e.g., the cover window 300 in FIG. 7) may include a protective layer (e.g., the protective layer 310 in FIG. 7), a glass (e.g., the glass 320 in FIG. 7) including a first glass (e.g., the first glass 321 in FIG. 7) and a second glass (e.g., the second glass 322 in FIG. 7) spaced apart from the first glass, a first adhesive layer (e.g., the first adhesive layer 330 in FIG. 7) at least partially located between the protective layer and the glass and at least partially having a first hardness, a second adhesive layer (e.g., the second adhesive layer 340 in FIG. 7) at least partially located under the glass and having a second hardness, and a third adhesive layer (e.g., the third adhesive layer 330 in FIG. 7) surrounded by the glass, the first adhesive layer, and the second adhesive layer and having a third hardness greater than the first hardness and less than the second hardness.

According to an embodiment, the cover window may include a first flat area (e.g., the first flat area 301 in FIG. 7), a second flat area (e.g., the second flat area 302 in FIG. 7) spaced apart from the first flat area, and a bending area (e.g., the bending area 303 in FIG. 7) located between the first flat area and the second flat area and accommodating the third adhesive layer.

According to an embodiment, the first adhesive layer may include a first portion (e.g., the first portion 331 in FIG. 8) located in the folding area, a second portion (e.g., the second portion 332 in FIG. 8) surrounding at least a portion of the first portion, and a third portion (e.g., the third portion 333 in FIG. 8) surrounding at least a portion of the second portion. A fourth hardness of the first portion, a fifth hardness of the second portion, and a sixth hardness of the third portion may be different.

According to an embodiment, the first glass may include a first end (e.g., the first end 324 in FIG. 6C) facing the second glass and having a chamfered shape.

The second glass may include a second end (e.g., the second end 325 in FIG. 6C) facing the first glass and having a chamfered shape. The third adhesive layer may be located between the first end and the second end.

According to an embodiment, the first adhesive layer may include a cushion area (e.g., the cushion area 339 in FIG. 9) located between the first glass and the second glass.

It will be apparent to those skilled in the art that the foldable electronic device including the cover window according to the disclosure described above is not limited by the foregoing embodiments and the drawings, and many replacements, variations, and changes may be made within the technical scope of the disclosure.

## Claims

1. An electronic device (101, 200) comprising:
a housing (202) including a first housing (210) and a second housing (220) rotatably connected to the first housing;
a foldable display (230) connected to the first housing and the second housing; and
a cover window (300) protecting the foldable display, and including a first flat area (301) connected to the first housing, a second flat area (302) connected to the second housing, and a bending area (303) located between the first flat area and the second flat area,
wherein the cover window includes:
a protective layer (310) forming at least a portion of an outer surface of the cover window;
a glass (320) including a first glass (321) at least partially located in the first flat area and a second glass (322) spaced apart from the first glass and at least partially located in the second flat area;
a first adhesive layer (330) at least partially located between the protective layer and the glass and having a first hardness;
a second adhesive layer (340) at least partially located between the glass and the display and having a second hardness; and
a third adhesive layer (350) surrounded by the glass, the first adhesive layer, and the second adhesive layer and having a third hardness greater than the first hardness and less than the second hardness.

2. The electronic device of claim 1, wherein the first glass includes a first end (324) facing the second glass and having a chamfered shape, and
wherein the second glass includes a second end (325) facing the first glass and having a chamfered shape.

3. The electronic device of any one of the preceding claims, wherein the glass includes a front surface (321a, 322a) facing the protective layer and a rear surface (321b, 322b) opposite to the front surface and facing the foldable display,
wherein the first adhesive layer includes a first flat portion (330a) located above the front surface, and a first protruding portion (330b) extending from the first flat portion and located above the first end, the second end, and the third adhesive layer, and
wherein the second adhesive layer includes a second flat portion (340a) located under the rear surface, and a second protruding portion (340b) extending from the second flat portion and located under the first end, the second end, and the third adhesive layer.

4. The electronic device of any one of the preceding claims, wherein the third adhesive layer is located between the first end and the second end.

5. The electronic device of any one of the preceding claims, wherein the foldable display includes a first display area (231) connected to the first housing, a second display area (232) connected to the second housing, and a folding area (233) located between the first display area and the second display area.

6. The electronic device of any one of the preceding claims, wherein the first adhesive layer includes a first portion (331) located above the folding area, a second portion (332) surrounding at least a portion of the first portion, and a third portion (333) surrounding at least a portion of the second portion, and
wherein a fourth hardness of the first portion, a fifth hardness of the second portion, and a sixth hardness of the third portion are different.

7. The electronic device of any one of the preceding claims, wherein the fifth hardness is greater than the fourth hardness, and
wherein the sixth hardness is greater than the fifth hardness.

8. The electronic device of any one of the preceding claims, wherein the first flat area is disposed on the first display area,
wherein the second flat area is disposed on the second display area, and
wherein the bending area is disposed on the folding area.

9. The electronic device of any one of the preceding claims, wherein the first adhesive layer includes a cushion area (339) located between the first glass and the second glass.

10. The electronic device of any one of the preceding claims, wherein the cover window includes a water-repellent coating layer (360) located between the first adhesive layer and the second adhesive layer.

11. The electronic device of any one of the preceding claims, wherein a thickness of the glass is thicker than a thickness of the protective layer.

12. The electronic device of any one of the preceding claims, wherein the first adhesive layer, the second adhesive layer, and the third adhesive layer include an optically clear resin.

13. The electronic device of any one of the preceding claims, wherein the first hardness ranges from a Shore hardness of 0 to a Shore hardness of 10,
wherein the second hardness ranges from the Shore hardness of 10 to a Shore hardness of 15, and
wherein the third hardness ranges from a Shore hardness of 16 to a Shore hardness of 20.

14. The electronic device of any one of the preceding claims, wherein a hardness of an adhesive layer including the first adhesive layer, the second adhesive layer, and the third adhesive layer gradually increases closer to the foldable display.

15. The electronic device of any one of the preceding claims, wherein the protective layer includes ultra-thin glass or a polyimide film.

## Patentansprüche

1. Elektronische Vorrichtung (101, 200), umfassend:
ein Gehäuse (202), das ein erstes Gehäuse (210) und ein zweites Gehäuse (220), das drehbar mit dem ersten Gehäuse verbunden ist, umfasst;
eine faltbare Anzeige (230), die mit dem ersten Gehäuse und dem zweiten Gehäuse verbunden ist; und
ein Abdeckfenster (300), das die faltbare Anzeige schützt und einen ersten flachen Bereich (301), der mit dem ersten Gehäuse verbunden ist, einen zweiten flachen Bereich (302), der mit dem zweiten Gehäuse verbunden ist, und einen Biegebereich (303), der sich zwischen dem ersten flachen Bereich und dem zweiten flachen Bereich befindet, umfasst,
wobei das Abdeckfenster umfasst:
eine Schutzschicht (310), die zumindest einen Abschnitt einer Außenfläche des Abdeckfensters ausbildet;
ein Glas (320), das ein erstes Glas (321), das sich zumindest teilweise im ersten flachen Bereich befindet, und ein zweites Glas (322), das vom ersten Glas beabstandet ist und sich zumindest teilweise im zweiten flachen Bereich befindet, umfasst;
eine erste Klebeschicht (330), die sich zumindest teilweise zwischen der Schutzschicht und dem Glas befindet und eine erste Härte aufweist;
eine zweite Klebeschicht (340), die sich zumindest teilweise zwischen dem Glas und der Anzeige befindet und eine zweite Härte aufweist; und
eine dritte Klebeschicht (350), die vom Glas, der ersten Klebeschicht und der zweiten Klebeschicht umgeben ist und eine dritte Härte aufweist, die größer ist als die erste Härte und kleiner als die zweite Härte.

2. Elektronische Vorrichtung nach Anspruch 1, wobei das erste Glas ein dem zweiten Glas zugewandtes erstes Ende (324) umfasst, das eine abgeschrägte Form aufweist, und
wobei das zweite Glas ein zweites Ende (325) umfasst, das dem ersten Glas zugewandt ist und eine abgeschrägte Form aufweist.

3. Elektronische Vorrichtung nach einem der vorhergehenden Ansprüche, wobei das Glas eine der Schutzschicht zugewandte Vorderseite (321a, 322a) und eine der Vorderseite gegenüberliegende, der faltbaren Anzeige zugewandte Rückseite (321b, 322b) umfasst,
wobei die erste Klebeschicht einen ersten flachen Abschnitt (330a), der sich über der Vorderseite befindet, und einen ersten vorstehenden Abschnitt (330b), der sich von dem ersten flachen Abschnitt aus erstreckt und sich über dem ersten Ende, dem zweiten Ende und der dritten Klebeschicht befindet, umfasst, und
wobei die zweite Klebeschicht einen zweiten flachen Abschnitt (340a), der sich unter der Rückseite befindet, und einen zweiten vorstehenden Abschnitt (340b), der sich von dem zweiten flachen Abschnitt aus erstreckt und sich unter dem ersten Ende, dem zweiten Ende und der dritten Klebeschicht befindet, umfasst.

4. Elektronische Vorrichtung nach einem der vorhergehenden Ansprüche, wobei sich die dritte Klebeschicht zwischen dem ersten Ende und dem zweiten Ende befindet.

5. Elektronische Vorrichtung nach einem der vorhergehenden Ansprüche, wobei die faltbare Anzeige einen ersten mit dem ersten Gehäuse verbundenen Anzeigebereich (231), einen zweiten mit dem zweiten Gehäuse verbundenen Anzeigebereich (232) und einen zwischen dem ersten und dem zweiten Anzeigebereich angeordneten Faltbereich (233) umfasst.

6. Elektronische Vorrichtung nach einem der vorhergehenden Ansprüche, wobei die erste Klebeschicht einen ersten Abschnitt (331), der sich über dem Faltbereich befindet, einen zweiten Abschnitt (332), der zumindest einen Abschnitt des ersten Abschnitts umgibt, und einen dritten Abschnitt (333), der zumindest einen Abschnitt des zweiten Abschnitts umgibt, umfasst, und
wobei sich eine vierte Härte des ersten Abschnitts, eine fünfte Härte des zweiten Abschnitts und eine sechste Härte des dritten Abschnitts voneinander unterscheiden.

7. Elektronische Vorrichtung nach einem der vorhergehenden Ansprüche, wobei die fünfte Härte größer ist als die vierte Härte, und
wobei die sechste Härte größer ist als die fünfte Härte.

8. Elektronische Vorrichtung nach einem der vorhergehenden Ansprüche, wobei der erste flache Bereich auf dem ersten Anzeigebereich angeordnet ist,
wobei der zweite flache Bereich auf dem zweiten Anzeigebereich angeordnet ist, und
wobei der Biegebereich auf dem Faltbereich angeordnet ist.

9. Elektronische Vorrichtung nach einem der vorhergehenden Ansprüche, wobei die erste Klebeschicht einen Polsterbereich (339) umfasst, der sich zwischen dem ersten Glas und dem zweiten Glas befindet.

10. Elektronische Vorrichtung nach einem der vorhergehenden Ansprüche, wobei das Abdeckfenster eine wasserabweisende Beschichtungsschicht (360) umfasst, die zwischen der ersten Klebeschicht und der zweiten Klebeschicht angeordnet ist.

11. Elektronische Vorrichtung nach einem der vorhergehenden Ansprüche, wobei die Dicke des Glases größer ist als die Dicke der Schutzschicht.

12. Elektronische Vorrichtung nach einem der vorhergehenden Ansprüche, wobei die erste Klebeschicht, die zweite Klebeschicht und die dritte Klebeschicht ein optisch klares Harz umfassen.

13. Elektronische Vorrichtung nach einem der vorhergehenden Ansprüche, wobei die erste Härte im Bereich von einer Shore-Härte von 0 bis zu einer Shore-Härte von 10 liegt,
wobei die zweite Härte im Bereich von einer Shore-Härte von 10 bis zu einer Shore-Härte von 15 liegt, und
wobei die dritte Härte im Bereich von einer Shore-Härte von 16 bis zu einer Shore-Härte von 20 liegt.

14. Elektronische Vorrichtung nach einem der vorhergehenden Ansprüche, wobei eine Härte einer Klebeschicht, die die erste Klebeschicht, die zweite Klebeschicht und die dritte Klebeschicht umfasst, in Richtung der faltbaren Anzeige allmählich zunimmt.

15. Elektronische Vorrichtung nach einem der vorhergehenden Ansprüche, wobei die Schutzschicht ultradünnes Glas oder einen Polyimidfilm umfasst.

## Revendications

1. Dispositif électronique (101, 200), comprenant :
un boîtier (202) comprenant un premier boîtier (210) et un deuxième boîtier (220) relié de manière rotative au premier boîtier ;
un affichage pliable (230) relié au premier boîtier et au deuxième boîtier ; et
une fenêtre de couverture (300) protégeant l'affichage pliable, et comprenant une première zone plane (301) reliée au premier boîtier, une deuxième zone plane (302) reliée au deuxième boîtier, et une zone de flexion (303) située entre la première zone plane et la deuxième zone plane,
dans lequel la fenêtre de couverture comprend :
une couche protectrice (310) formant au moins une partie de la surface extérieure de la fenêtre de couverture ;
un verre (320) comprenant un premier verre (321) situé au moins partiellement dans la première zone plane et un deuxième verre (322) espacé du premier verre et situé au moins partiellement dans la deuxième zone plane ;
une première couche adhésive (330) située au moins partiellement entre la couche protectrice et le verre et présentant une première dureté ;
une deuxième couche adhésive (340) située au moins en partie entre le verre et l'affichage et présentant une deuxième dureté ; et
une troisième couche adhésive (350) entourée par le verre, la première couche adhésive et la deuxième couche adhésive, et présentant une troisième dureté supérieure à la première dureté et inférieure à la deuxième dureté.

2. Dispositif électronique selon la revendication 1, dans lequel le premier verre comprend une première extrémité (324) faisant face au deuxième verre et présentant une forme chanfreinée, et
dans lequel le deuxième verre comporte une deuxième extrémité (325) faisant face au premier verre et présentant une forme chanfreinée.

3. Dispositif électronique selon l'une quelconque des revendications précédentes, dans lequel le verre comprend une surface avant (321a, 322a) faisant face à la couche protectrice et une surface arrière (321b, 322b) opposée à la surface avant et faisant face à l'affichage pliable,
dans lequel la première couche adhésive comprend une première partie plane (330a) située au-dessus de la surface avant, et une première partie saillante (330b) s'étendant à partir de la première partie plane et située au-dessus de la première extrémité, de la deuxième extrémité et de la troisième couche adhésive, et
dans lequel la deuxième couche adhésive comprend une deuxième partie plane (340a) située sous la surface arrière, et une deuxième partie saillante (340b) s'étendant à partir de la deuxième partie plane et située sous la première extrémité, la deuxième extrémité et la troisième couche adhésive.

4. Dispositif électronique selon l'une quelconque des revendications précédentes, dans lequel la troisième couche adhésive est située entre la première extrémité et la deuxième extrémité.

5. Dispositif électronique selon l'une quelconque des revendications précédentes, dans lequel l'affichage pliable comprend une première zone d'affichage (231) reliée au premier boîtier, une deuxième zone d'affichage (232) reliée au deuxième boîtier, et une zone de pliage (233) située entre la première zone d'affichage et la deuxième zone d'affichage.

6. Dispositif électronique selon l'une quelconque des revendications précédentes, dans lequel la première couche adhésive comprend une première partie (331) située au-dessus de la zone de pliage, une deuxième partie (332) entourant au moins une partie de la première partie, et une troisième partie (333) entourant au moins une partie de la deuxième partie, et
dans lequel une quatrième dureté de la première partie, une cinquième dureté de la deuxième partie et une sixième dureté de la troisième partie sont différentes.

7. Dispositif électronique selon l'une quelconque des revendications précédentes, dans lequel la cinquième dureté est supérieure à la quatrième dureté, et
dans lequel la sixième dureté est supérieure à la cinquième dureté.

8. Dispositif électronique selon l'une quelconque des revendications précédentes, dans lequel la première zone plane est disposée sur la première zone d'affichage,
dans lequel la deuxième zone plane est disposée sur la deuxième zone d'affichage, et
dans lequel la zone de flexion est disposée sur la zone de pliage.

9. Dispositif électronique selon l'une quelconque des revendications précédentes, dans lequel la première couche adhésive comprend une zone d'amortissement (339) située entre le premier verre et le deuxième verre.

10. Dispositif électronique selon l'une quelconque des revendications précédentes, dans lequel le verre de couverture comprend une couche de revêtement hydrofuge (360) située entre la première couche adhésive et la deuxième couche adhésive.

11. Dispositif électronique selon l'une quelconque des revendications précédentes, dans lequel l'épaisseur du verre est supérieure à celle de la couche protectrice.

12. Dispositif électronique selon l'une quelconque des revendications précédentes, dans lequel la première couche adhésive, la deuxième couche adhésive et la troisième couche adhésive comprennent une résine optiquement transparente.

13. Dispositif électronique selon l'une quelconque des revendications précédentes, dans lequel la première dureté est comprise entre une dureté Shore de 0 et une dureté Shore de 10,
dans lequel la deuxième dureté est comprise entre une dureté Shore de 10 et une dureté Shore de 15, et
dans lequel la troisième dureté est comprise entre une dureté Shore de 16 et une dureté Shore de 20.

14. Dispositif électronique selon l'une quelconque des revendications précédentes, dans lequel la dureté d'une couche adhésive comprenant la première couche adhésive, la deuxième couche adhésive et la troisième couche adhésive augmente progressivement à mesure que l'on se rapproche de l'affichage pliable.

15. Dispositif électronique selon l'une quelconque des revendications précédentes, dans lequel la couche protectrice comprend du verre ultra-fin ou un film de polyimide.
